# FASCICULE DE BREVET EUROPEEN

(11) **EP 2 084 435 B1**
(45) Date de publication et mention de la délivrance du brevet: **30.05.2012**
(21) Numéro de dépôt: 07858474.5
(22) Date de dépôt: 17.10.2007
(51) Int. Cl.: F16J 15/00

(54) **DISPOSITIF À DOUBLE ÉTANCHÉITÉ POUR UNE MACHINE DE TRAITEMENT DE RÉCIPIENTS PAR PLASMA**
DOPPELDICHTUNG FÜR EINE MASCHINE ZUR PLASMABEHANDLUNG VON BEHÄLTERN
DOUBLE-SEALING DEVICE FOR A MACHINE FOR THE PLASMA TREATMENT OF CONTAINERS

(30) Priorité: 18.10.2006 FR 0609142
(43) Date de publication de la demande: 05.08.2009
(73) Titulaire: Sidel Participations, 76930 Octeville Sur Mer (FR)
(72) Inventeur: DUCLOS, Yves-Alban, 76930 Octeville sur Mer (FR)
(74) Mandataire: Demulsant, Xavier
(86) Numéro de dépôt international: PCT/FR2007/001717
(87) Numéro de publication internationale: WO 2008/050001

(56) Documents cités:
- BE-A- 399 856
- FR-A- 2 872 148

## Description

L'invention concerne le traitement des récipients, consistant au moyen d'un plasma à revêtir leur paroi interne d'une couche d'un matériau à effet barrière.

A cet effet, on utilise classiquement une machine comprenant un générateur d'ondes électromagnétiques, une cavité reliée au générateur et réalisée dans un matériau conducteur (généralement métallique), et une enceinte disposée dans la cavité et réalisée dans un matériau (généralement du quartz) transparent aux ondes électromagnétiques en provenance du générateur.

Après introduction du récipient (généralement réalisé dans un matériau polymère thermoplastique tel que PET) dans l'enceinte, on les dépressurise tous les deux pour obtenir, d'une part, dans le récipient, un vide poussé (de quelques µbars - rappelons que 1 µbar = 10⁻⁶ bar) nécessaire à l'établissement du plasma et, d'autre part, dans l'enceinte à l'extérieur du récipient, un vide moyen (de l'ordre de 30 mbar à 100 mbar) pour éviter que le récipient ne se contracte sous l'effet de la différence de pression de part et d'autre de sa paroi.

Un gaz précurseur (tel que de l'acétylène, C₂H₂) est ensuite introduit dans le récipient, ce précurseur étant activé par bombardement électromagnétique (il s'agit généralement de micro-ondes UHF à 2,45 GHz, de faible puissance) pour le faire passer à l'état de plasma froid et ainsi générer des espèces incluant du carbone hydrogéné (comprenant CH, CH₂, CH₃), lequel se dépose en couche mince (dont l'épaisseur est classiquement comprise entre 50 et 200 nm selon les cas - rappelons que 1 nm = 10⁻⁹ m) sur la paroi interne du récipient.

Il est essentiel, au cours du traitement, d'éviter toute communication entre l'intérieur et l'extérieur du récipient. A défaut, la surpression régnant à l'extérieur du récipient entraînerait l'injection d'air dans celui-ci et une oxydation des espèces générées par le plasma, au détriment de la qualité de la couche barrière déposée.

C'est pourquoi les machines de traitement connues sont équipées de dispositifs d'étanchéité comprenant un joint annulaire contre lequel vient s'appliquer l'ouverture (également appelée buvant) du récipient lors de son introduction dans la machine. A titre d'illustration, on pourra se référer à la demande de brevet français FR 2 872 148 (Sidel) ou à la demande internationale équivalente WO 2006/000539, ou encore au brevet américain US 5 849 366.

Cette technique est perfectible. En effet, des fuites ont été constatées au niveau du joint d'étanchéité. Ces fuites sont dues au dépôt progressif, sur le joint, d'espèces carbonées générées par le plasma. Au cours du temps, ce dépôt forme à la surface du joint un film qui diminue la flexibilité de celui-ci, des jours apparaissant à l'interface entre le joint et le buvant du récipient. Afin d'éviter que de telles fuites ne se produisent, la solution qui a cours actuellement est le nettoyage ou le remplacement du joint, ce qui implique une immobilisation de la machine pendant la durée de l'intervention.

L'invention vise à perfectionner l'étanchéité des machines de traitement des récipients.

A cet effet, l'invention propose un dispositif d'étanchéité pour une machine de traitement de récipients par plasma, qui comprend au moins une première et une deuxième surfaces annulaires d'étanchéité, propres à coopérer respectivement avec une première et une deuxième zones annulaires distinctes d'un col de récipient.

Ce dispositif procure sur le récipient une double étanchéité qui permet de réduire la fréquence de dépollution ou de remplacement du joint pollué, au bénéfice de la productivité.

Suivant un mode de réalisation, la première surface est propre à coopérer avec un buvant du récipient. La deuxième surface est par exemple propre à coopérer avec une collerette du récipient.

Les surfaces d'étanchéité peuvent être portées par au moins un joint d'étanchéité, et par exemple par deux joints d'étanchéité distincts.

Suivant un mode de réalisation, le dispositif comprend une douille, propre à recevoir le col du récipient et formant une armature pour le ou chaque joint d'étanchéité. Cette douille comprend par exemple un corps cylindrique prolongé par une jupe tubulaire. Un premier joint d'étanchéité peut être emboîté dans un lamage formé dans la douille à la jonction entre le corps et la jupe, tandis qu'un second joint d'étanchéité est par exemple monté sur la jupe. Suivant un mode de réalisation, un évent met en communication un espace interne délimité par la jupe, avec l'extérieur de la douille.

L'invention propose également une machine de traitement de récipients par plasma, qui comprend un dispositif d'étanchéité tel que décrit ci-dessus.

D'autres objets et avantages de l'invention apparaîtront à la lumière de la description faite ci-après en référence aux dessins annexés dans lesquels :
- la figure 1 est une vue d'élévation en coupe d'une machine de traitement de récipients comprenant un dispositif perfectionné d'étanchéité ;

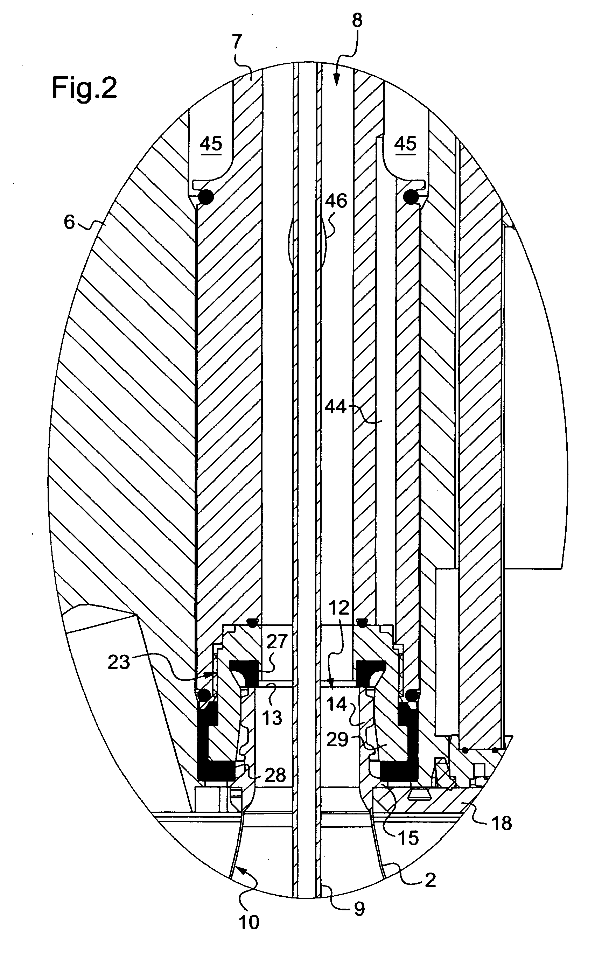

- la figure 2 est une vue en coupe, à échelle agrandie, d'un détail de la machine de la figure 1 ;
- la figure 3 est une vue en coupe, à échelle agrandie, d'un détail de la machine de la figure 2, montrant un dispositif perfectionné d'étanchéité ;

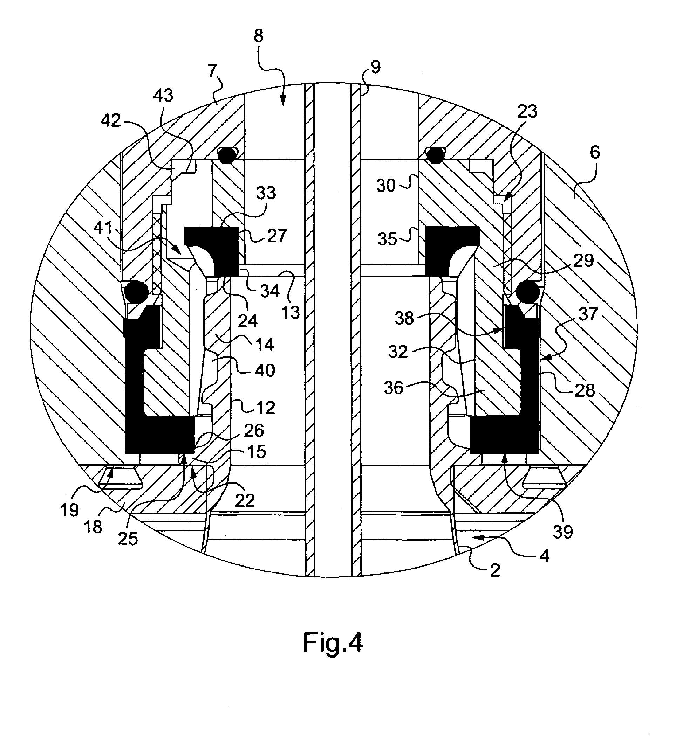

- la figure 4 est une vue de détail en coupe du dispositif d'étanchéité de la figure 3, suivant le plan de coupe IV-IV ;

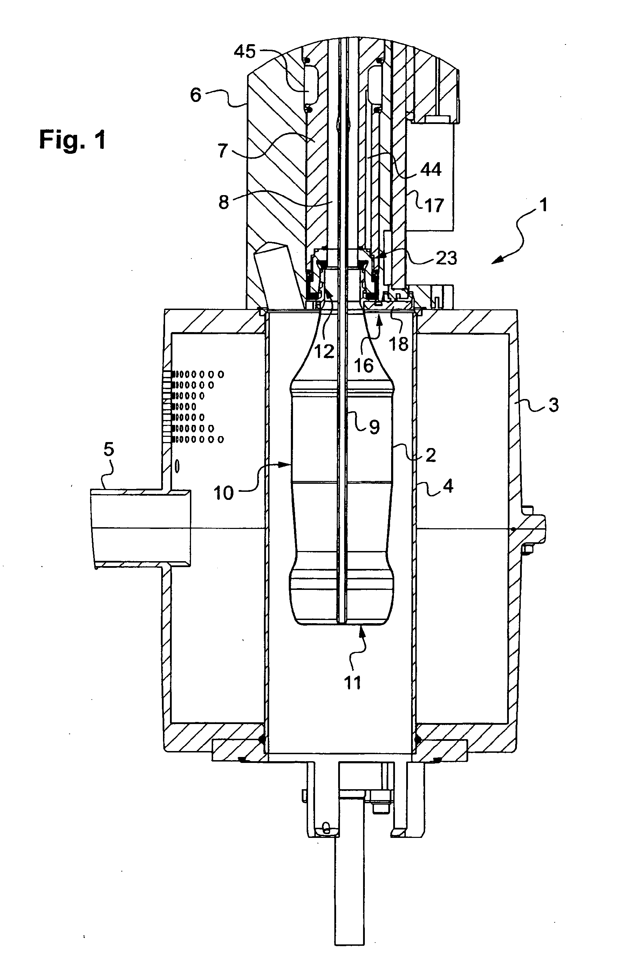

Sur la figure 1 est représentée une machine 1 de traitement de récipients **2** préalablement mis en forme par soufflage ou étirage soufflage à partir d'ébauches en matière plastique, par exemple en PET. Le traitement consiste à effectuer un dépôt par plasma, sur la paroi interne des récipients, d'une couche barrière comprenant du carbone hydrogéné.

La machine **1** comprend une cavité **3** réalisée dans un matériau conducteur, par exemple en acier ou (de préférence) en aluminium ou dans un alliage d'aluminium. Dans la cavité **3** est disposée une enceinte **4** réalisée dans un matériau transparent aux ondes électromagnétiques, tel que du quartz. La machine **1** comprend également un générateur (non représenté) de micro-ondes électromagnétique de faible puissance à une fréquence de 2,45 GHz, relié à la cavité **3** par un guide **5** d'ondes.

La cavité **4** est surmontée d'un couvercle **6** dans lequel est montée une chemise **7** définissant, dans le prolongement de l'enceinte **4** à une extrémité supérieure de celle-ci, une tuyère **8** traversée axialement par un injecteur **9** au moyen duquel un gaz précurseur, tel que de l'acétylène, est introduit dans le récipient **2**.

Le récipient **2** destiné à être traité comprend un corps **10** qui définit le volume interne du récipient **2**, ce corps **10** se terminant par un fond **11** et se prolongeant, à l'opposé du fond **11**, par un col **12** présentant une épaisseur de paroi supérieure à celle du corps **10**. Le col **12** définit une ouverture **13** annulaire, également appelée buvant. Sur sa paroi externe, le col **12** présente des aspérités **14**, telles que des nervures ou un filet, au moyen desquelles il est possible, après avoir rempli le récipient **2**, de fixer de manière amovible un bouchon. Le col **12** comprend en outre, au-dessous des aspérités **14** au voisinage du corps **10**, une collerette **15** permettant la préhension du récipient **2** au cours des différentes étapes de sa fabrication puis de son remplissage.

Le récipient **2** représenté sur les dessins est une bouteille. Son col **12** est par conséquent d'un diamètre inférieur au corps **10**. Toutefois, la présente description n'est pas limitée aux bouteilles mais peut s'appliquer à tout type de récipient, y compris ceux dont le col est d'un diamètre équivalent, voire supérieur à celui du corps.

La machine **1** est équipée d'un dispositif **16** de préhension du récipient **2**, qui comprend une tige **17** montée coulissante par rapport au couvercle **6**, à une extrémité inférieure de laquelle est fixée une pince **18**, également appelée fourchette, qui saisit le récipient **2** sous son col **12** et en assure la sustentation.

Le dispositif **16** de préhension est mobile entre une position basse (non représentée), où la fourchette **18** fait saillie sous la cavité **3** pour permettre le chargement d'un récipient **2**, et une position haute (représentée sur les figures) où la fourchette **18** vient buter contre une paroi supérieure **19** de la cavité et maintient le col **12** du récipient **2** à l'intérieur du couvercle **6**, dans le prolongement de la tuyère **8**.

Pour assurer la sustentation du récipient **2**, la fourchette **18** définit une ouverture **20** semi-circulaire dans laquelle le récipient **2** est encliqueté et sur un bord **21** supérieur de laquelle celui-ci repose, en appui par une face **22** inférieure de la collerette **15.**

La machine **1** est en outre équipée d'un dispositif **23** d'étanchéité, monté dans le couvercle **6** à une extrémité inférieure de la chemise **7**. Ce dispositif **23** d'étanchéité comprend au moins deux surfaces **24**, **25** d'étanchéité contre lesquelles le récipient **2** vient s'appuyer par l'intermédiaire de deux zones **13**, **15** annulaires distinctes de son col **12**.

Plus précisément, un première surface **24** d'étanchéité, dite surface supérieure d'étanchéité, coopère avec le buvant **13** du récipient **2**, tandis qu'une deuxième surface **25** d'étanchéité, dite surface inférieure d'étanchéité, coopère avec la collerette **15**, et plus exactement avec une face **26** supérieure de celle-ci, opposée à la face inférieure **22**.

Le positionnement axial des surfaces **24**, **25** d'étanchéité est effectué de sorte que le buvant **13** et la face **26** supérieure de la collerette **15** viennent repousser les surfaces **24**, **25** d'étanchéité grâce à l'élasticité de leurs supports respectifs.

Les surfaces **24**, **25** d'étanchéité sont portées par au moins un joint élastique. Suivant un mode de réalisation préféré, illustré sur les figures, les surfaces **24**, **25** d'étanchéité sont portées respectivement par deux joints **27**, **28** élastiques distincts, réalisés dans une matière compressible tel que silicone ou caoutchouc (naturel ou synthétique).

Plus précisément, la surface **24** supérieure d'étanchéité est formée sur un premier joint **27**, dit joint de buvant, tandis que la surface **25** inférieure d'étanchéité est formée sur un second joint **28**, dit joint de collerette.

Afin d'assurer le maintien et le positionnement correct des joints **27**, **28**, le dispositif **23** d'étanchéité comprend une douille **29** réalisée dans un matériau rigide, par exemple en aluminium ou, de préférence, en acier. Cette douille **29** présente, du côté de la chemise **7** contre laquelle elle est en appui et dans laquelle elle est emmanchée (ou, de préférence, vissée), un corps **30** cylindrique percé d'un trou **31** traversant qui s'étend coaxialement et dans le prolongement de la tuyère **8**. Le corps **30** se prolonge, à l'opposé de la chemise **7**, par une jupe **32** tubulaire qui définit intérieurement un logement dans lequel est reçu au moins en partie le col **12** du récipient **2**.

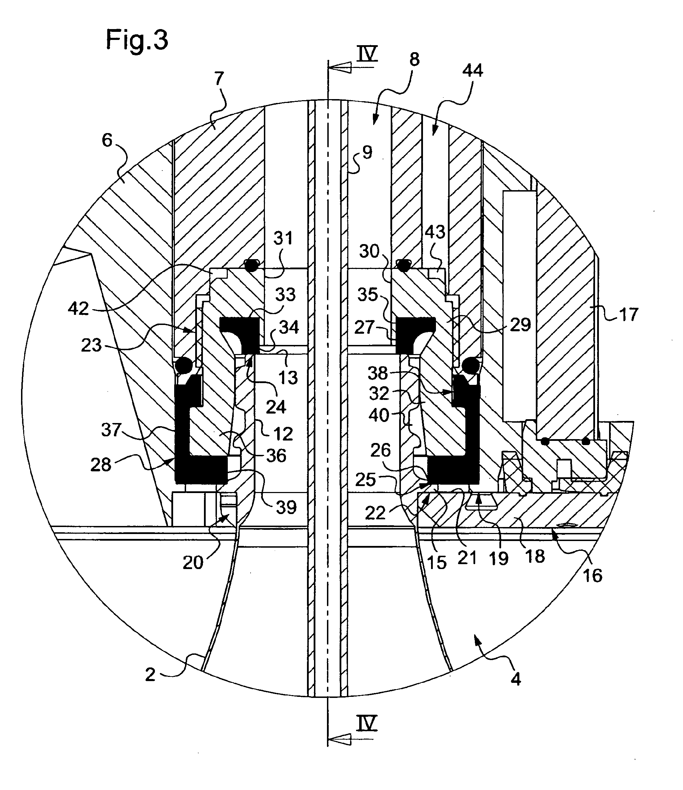

Comme cela est visible notamment sur la figure 3, le joint **27** de buvant présente en section un profil en cornière ; il est reçu dans un lamage **33** réalisé dans la douille **29** à la jonction entre le corps **30** et la jupe **32** et présente une portion inférieure **34** qui s'étend en saillie en direction de l'enceinte **4** et à l'extrémité de laquelle est formée la surface **24** supérieure d'étanchéité, qui s'étend annulairement dans un plan perpendiculaire à l'axe de la tuyère **8**. La surface **24** supérieure d'étanchéité présente radialement une dimension supérieure à celle du buvant **13**, de sorte qu'elle déborde de celui-ci et en épouse la courbure pour améliorer l'étanchéité du contact.

Le lamage **33** est bordé intérieurement par une saillie **35** tubulaire qui sert d'armature au joint **27** de buvant, afin d'éviter que sous la pression exercée par le récipient **2** le joint **27** ne s'écrase trop.

Le joint **28** de collerette est quant à lui monté sur la jupe **32** qui lui sert d'armature et dont il épouse un bourrelet **36** annulaire qui fait saillie radialement. Le joint **28** de collerette comprend une portion **37** centrale cylindrique, qui circonscrit le bourrelet **36** et se prolonge, d'une part, du côté de la chemise **7**, au-delà du bourrelet **36**, par un premier retour **38** annulaire de moindre diamètre, et d'autre part, du côté de l'enceinte **4**, par un second retour **39** annulaire qui prolonge axialement la jupe **32** et à l'extrémité duquel est formée la surface **25** inférieure d'étanchéité, qui, comme la surface **24** supérieure, s'étend annulairement dans un plan perpendiculaire à l'axe de la tuyère **8**.

Le joint **27** de buvant, en contact avec le plasma, peut au cours des cycles de traitement répétés, se couvrir peu à peu de particules carbonées. Toutefois, un tel dépôt n'aboutit pas à l'apparition de fuites entre le récipient **2** et l'enceinte **4**, grâce à la présence du joint **28** de collerette. Cette double étanchéité réalisée sur le récipient **2** permet à tout le moins d'espacer les interventions visant à dépolluer ou remplacer le joint **27** de buvant.

Le col **12** du récipient **2** d'une part, la douille **29** et le joints **27**, 28 d'autre part, définissent entre eux un interstice **40** annulaire qui se trouve isolé de l'intérieur du récipient **2** par le joint **27** de buvant, contre lequel vient s'appliquer le buvant **13**, et de l'enceinte **4** par le joint **28** de collerette contre lequel vient s'appliquer la collerette **15**.

Lors de l'introduction du col **12** dans la douille **29,** avant que ne débute le traitement, cet interstice **40** est à la pression atmosphérique. Le vide étant réalisé tant dans le récipient **2** que dans l'enceinte **4**, il existe un risque que la surpression régnant alors dans l'interstice **40** provoque des fuites au niveau des joints **27**, **28**. Afin d'éliminer ce risque, l'interstice **40** est raccordé à la tuyère **8** au moyen d'évents **41** pratiqués radialement et/ou axialement dans le corps **30** de la douille **29**, ces évents **41** mettant en communication l'espace délimité inférieurement par la jupe (et donc l'interstice **40**) avec une face extérieure de la douille **29**, et plus précisément avec un espace **42** annulaire défini entre la chemise **7** et la douille **29** au moyen d'un lamage **43** pratiqué dans celle-ci.

Un canal **44**, percé axialement dans l'épaisseur de la chemise **7**, débouche dans cet espace **42** annulaire qu'il met en communication avec une chambre **45** annulaire creusée dans la chemise **7**, laquelle chambre **45** communique d'une part avec la tuyère **8** par des trous **46** obliques, et d'autre part avec un conduit de mise à l'air libre par l'intermédiaire d'une électrovanne (non représentée).

Ainsi, d'une part, lors de la mise au vide du récipient **2**, l'air résiduel présent dans l'interstice **40** est aspiré via les évents **41** et le canal **44.** La pression régnant in fine dans l'interstice **40** est égale, ou sensiblement égale, à celle régnant dans le récipient **2**. La (légère) différence de pression qui existe de part et d'autre de la collerette **15** tend donc à plaquer celle-ci davantage encore contre le joint **28** de collerette.

D'autre part, lors de la remise à la pression atmosphérique du récipient **2**, de l'air non pollué parvient dans l'interstice **40** depuis la chambre **45** (mise à l'air libre par ouverture de l'électrovanne), via le canal **44**. Il en résulte une pollution minimale de l'interstice **40** et donc de la surface **25** d'étanchéité.

L'invention n'est pas limitée aux formes de réalisation qui viennent d'être décrites, mais à celles conformes aux revendications.

En particulier, si les joints **27**, **28** sont de préférence, comme cela est décrit ci-dessus, des pièces fabriquées séparément de la douille **29**, rapportées et fixées sur celle-ci par simple emboîtement ou emmanchement, ils pourraient toutefois, en variante, être surmoulés sur la douille **29**.

De même, nous avons vu que les surfaces **24**, **25** d'étanchéité sont réalisées sur deux joints **27**, **28** distincts. En variante, ces surfaces pourraient appartenir à un joint unique qui pourrait, par exemple, être surmoulé sur la douille **29**. Dans cette hypothèse, le joint pourrait recouvrir la face interne de la jupe **32**.

## Revendications

1. Dispositif **(23)** d'étanchéité pour une machine **(1)** de traitement de récipients **(2)** par plasma, **caractérisé en ce qu'**il comprend au moins une première et une deuxième surfaces **(24, 25)** annulaires d'étanchéité, propres à coopérer respectivement avec une première et une deuxième zones **(13, 15)** annulaires distinctes d'un col **(12)** de récipient **(2),** à savoir un buvant **(13)** d'une part et une collerette **(15)** d'autre part.

2. Dispositif **(23)** selon la revendication 1, dans lequel les surfaces **(24, 25)** d'étanchéité sont portées par au moins un joint d'étanchéité.

3. Dispositif **(23)** selon la revendication 2, dans lequel les surfaces **(24, 25)** d'étanchéité sont portées par deux joints **(27, 28)** d'étanchéité distincts.

4. Dispositif **(23)** d'étanchéité selon la revendication 2 ou 3, qui comprend une douille **(29)** propre à recevoir le col **(12)** du récipient **(2),** cette douille **(29)** formant une armature pour le ou chaque joint **(27, 28)** d'étanchéité.

5. Dispositif **(23)** selon la revendication 4, dans lequel la douille **(29)** comprend un corps **(30)** cylindrique prolongé par une jupe **(32)** tubulaire.

6. Dispositif **(23)** selon les revendications 3 et 5, prises en combinaison, dans lequel le premier joint **(24)** d'étanchéité est emboîté dans un lamage **(33)** formé dans la douille **(29)** à la jonction entre le corps **(30)** et la jupe **(32),** et le second joint **(25)** d'étanchéité est monté sur la jupe **(32).**

7. Dispositif **(23)** selon la revendication 5 ou 6, qui comprend au moins un évent **(41)** mettant en communication un espace délimité intérieurement par la jupe **(32)**, avec l'extérieur de la douille **(29)**.

8. Machine **(1)** de traitement de récipients par plasma, qui comprend un dispositif **(23)** d'étanchéité selon l'une des revendications 1 à 7.

## Claims

1. Sealing device (23) for a machine (1) for the plasma treatment of containers (2), **characterized in that** it comprises at least one first and one second annular sealing surfaces (24, 25), suitable for interacting respectively with a first and a second distinct annular zone (13, 15) of a neck (12) of a container (2), namely a locking ring (13) on the one hand and a collar (15) on the other hand.

2. Device (23) according to Claim 1, in which the sealing surfaces (24, 25) are supported by at least one seal.

3. Device (23) according to Claim 2, in which the sealing surfaces (24, 25) are supported by two distinct seals (27, 28).

4. Sealing device (23) according to Claim 2 or 3, which comprises a socket (29) suitable for accommodating the neck (12) of the container (2), this socket (29) forming a reinforcement for the or each seal (27, 28).

5. Device (23) according to Claim 4, in which the socket (29) comprises a cylindrical body (30) extended by a tubular skirt (32).

6. Device (23) according to Claims 3 and 5, taken in combination, in which the first seal (24) is fitted into a facing (33) formed in the socket (29) at the junction between the body (30) and the skirt (32), and the second seal (25) is mounted on the skirt (32).

7. Device (23) according to Claim 5 or 6, which comprises at least one vent (41) placing a space delimited internally by the skirt (32) in communication with the outside of the socket (29).

8. Machine (1) for the plasma treatment of containers, which comprises a sealing device (23) according to one of Claims 1 to 7.

## Patentansprüche

1. Dichtungsvorrichtung (23) für eine Maschine (1) zur Bearbeitung von Aufnahmebehältern (2) mittels Plasma, **dadurch gekennzeichnet, dass** sie wenigstens eine erste und eine zweite ringförmige Dichtungsoberfläche (24, 25) umfasst, die dazu ausgelegt sind, mit einer ersten bzw. einer zweiten ringförmigen Zone (13, 15) eines Halses (12) des Aufnahmebehälters (2), die voneinander verschieden sind, nämlich mit einem Trinkrand (13) einerseits und mit einem Kranz (15) andererseits, zusammenzuwirken.

2. Vorrichtung (23) nach Anspruch 1, wobei die Dichtungsoberflächen (24, 25) durch wenigstens eine Dichtungsschnur getragen werden.

3. Vorrichtung (23) nach Anspruch 2, wobei die Dichtungsoberflächen (24, 25) durch zwei verschiedene Dichtungsschnüre (27, 28) getragen werden.

4. Dichtungsvorrichtung (23) nach Anspruch 2 oder 3, die eine Hülse (29) aufweist, die den Hals (12) des Aufnahmebehälters (2) aufnehmen kann, wobei diese Hülse (29) einen Umhüllung für die oder jede Dichtungsschnur (27, 28) bildet.

5. Vorrichtung (23) nach Anspruch 4, wobei die Hülse (29) einen durch eine rohrförmige Schürze (32) verlängerten zylindrischen Körper (30) umfasst.

6. Vorrichtung (23) nach den Ansprüchen 3 und 5 in Kombination, wobei die erste Dichtungsschnur (24) in eine in der Hülse (29) an der Verbindungsstelle zwischen dem Körper (30) und der Schürze (32) ausgebildete Vertiefung (33) eingebettet ist und die zweite Dichtungsschnur (25) an der Schürze (32) montiert ist.

7. Vorrichtung (23) nach Anspruch 5 oder 6, die wenigstens ein Lüftungsloch (41) aufweist, das eine Kommunikation zwischen einem begrenzten Raum innerhalb der Schürze (32) und der äußeren Umgebung der Hülse (29) herstellt.

8. Maschine (1) zur Bearbeitung von Aufnahmebehältern mittels Plasma, die eine Dichtungsvorrichtung (23) nach einem der Ansprüche 1 bis 7 umfasst.
